# EUROPEAN PATENT APPLICATION

(11) **EP 4 675 625 A2**
(43) Date of publication of application: **07.01.2026**
(21) Application number: 25157881.1
(22) Date of filing: 14.02.2025
(51) Int. Cl.: G11C 7/20, G11C 16/20

(54) **MANAGING INITIALIZATION IN MEMORY DEVICES**

(30) Priority: 05.07.2024 CN 202410903230
(71) Applicant: Yangtze Memory Technologies Co., Ltd., Wuhan, Hubei 430000 (CN)
(72) Inventor: YU, Kaikai, Wuhan, Hubei, 430000 (CN); PENG, Yangqun, Wuhan, Hubei, 430000 (CN)
(74) Representative: Gramm, Lins & Partner Patent- und Rechtsanwälte PartGmbB

(57) **Abstract**

Methods, devices, and systems for managing initialization in memory devices are provided. In one aspect, a memory device including a memory array and a peripheral circuit coupled to the memory array. The memory array includes memory banks. The peripheral circuit is configured to perform operations including receiving a write initialization command, and in response to the write initialization command, initializing the one or more memory banks. The write initialization command includes an instruction to initialize one or more memory banks.

## Description

### TECHNICAL FIELD

The present disclosure relates to semiconductor devices, e.g., memory devices.

### BACKGROUND

In a non-volatile memory device, such as a NAND Flash memory, or a NOR Flash memory, data stored in the memory device are preserved when power is turned off. In contrast, in a volatile memory device, such as a Dynamic Random Access Memory (DRAM) or a Static Random Access Memory (SRAM), data stored in the memory device are lost when power is turned off.

### SUMMARY

The present disclosure describes managing initialization in memory devices. Initialization in memory devices includes writing pre-set data in memory cells of the memory devices.

One aspect of the present disclosure features a memory device including a memory array and a peripheral circuit coupled to the memory array. The memory array includes memory banks. The peripheral circuit is configured to perform operations including receiving a write initialization command, and in response to the write initialization command, initializing the one or more memory banks. The write initialization command includes an instruction to initialize one or more memory banks.

In some implementations, initializing the one or more memory banks includes writing pre-set data in memory cells of the one or more memory banks.

In some implementations, a first register of the peripheral circuit stores the pre-set data.

In some implementations, a first identifier of the write initialization command indicates the pre-set data.

In some implementations, the write initialization command includes a second identifier identifying the write initialization command.

In some implementations, the memory banks are arranged into a plurality of bank groups. Initializing the one or more memory banks includes initializing all memory banks of the plurality of bank groups.

In some implementations, the memory banks are arranged into a plurality of bank groups. Initializing the one or more memory banks includes initializing a target memory bank of a bank group of the plurality of bank groups.

In some implementations, the write initialization command includes a third identifier indicating whether to initialize all memory banks or the target memory bank of a bank group of the plurality of bank groups, and a fourth identifier indicating the target memory bank.

In some implementations, the operations include, after receiving the write initialization command, receiving a command to perform an operation on the one or more memory banks after a pre-set duration. The memory device initializes the one or more memory banks during the pre-set duration.

In some implementations, the peripheral circuit includes a second register. The operations include setting a status of the second register indicating whether the one or more memory banks are initialized.

In some implementations, the operations include, after receiving the write initialization command, setting a voltage of a data input/output (I/O) pin to a first state, and after initializing the one or more memory banks, setting the voltage of the data I/O pin to a second state.

In some implementations, the memory device includes a dynamic random access memory (DRAM) memory device.

One aspect of the present disclosure features a memory system. The memory system includes a memory device and a memory controller coupled to the memory device. The memory controller is configured to send a write initialization command that includes an instruction to initialize one or more memory banks of the memory device. The memory device is configured to receive the write initialization command and initialize the one or more memory banks.

In some implementations, the memory banks are arranged into a plurality of bank groups. Initializing the one or more memory banks includes initializing all memory banks of the plurality of bank groups.

In some implementations, the memory banks are arranged into a plurality of bank groups. Initializing the one or more memory banks includes initializing a target memory bank of a bank group the plurality of bank groups.

In some implementations, the write initialization command includes a first identifier indicating whether to initialize all memory banks or the target memory bank of a bank group sof the plurality of bank groups, and a second identifier indicating the target memory bank.

In some implementations, the operations include, after receiving the write initialization command, receiving a command to perform an operation on the one or more memory banks after a pre-set duration.

In some implementations, the peripheral circuit includes a second register. The operations include setting a status of the second register indicating whether the one or more memory banks are initialized.

In some implementations, the operations include, after receiving the write initialization command, setting a voltage of a data input/output (I/O) pin to a first state, and after initializing the one or more memory banks, setting the voltage of the data I/O pin to a second state.

One aspect of the present disclosure features a method of operating a memory device. The method includes receiving a write initialization command, and in response to the write initialization command, initializing the one or more memory banks. The write initialization command includes an instruction to initialize one or more memory banks of the memory device.

The details of one or more implementations of the subject matter of this present disclosure are set forth in the accompanying drawings and the description below. Other features, aspects, and advantages of the subject matter will become apparent from the description, the drawings, and the claims.

### BRIEF DESCRIPTION OF THE DRAWINGS

The accompanying drawings, which are incorporated herein and form a part of the present disclosure, illustrate aspects of the present disclosure and, together with the description, further serve to explain the principles of the present disclosure and to enable a person of ordinary skill in the pertinent art to make and use the present disclosure.
FIG. 1 illustrates a block diagram of an example system having one or more semiconductor devices , according to some aspects of the present disclosure.
FIG. 2 illustrates a schematic diagram of an example memory device including a peripheral circuit and an array of memory cells each having a vertical transistor, according to some aspects of the present disclosure.
FIG. 3 illustrates memory device having a memory array and an example peripheral circuit, according to some aspects of the present disclosure.
FIG. 4 illustrates a data structure of an example write initialization command, according to some aspects of the present disclosure.
FIG. 5A illustrates a schematic timing diagram of an example method of initializing a memory device, according to some aspects of the present disclosure.
FIG. 5B illustrates the example method of initializing the memory device in FIG. 5A, according to some aspects of the present disclosure.
FIG. 6A illustrates a schematic timing diagram of another example method of initializing a memory device, according to some aspects of the present disclosure.
FIG. 6B illustrates the example method of initializing the memory device in FIG. 6A, according to some aspects of the present disclosure.
FIG. 7A illustrates a schematic timing diagram of yet another example method of initializing a memory device, according to some aspects of the present disclosure.
FIG. 7B illustrates the example method of initializing the memory device in FIG. 7A, according to some aspects of the present disclosure.
FIG. 8 illustrates a flow chart of an example process of initializing a memory device, according to some aspects of the present disclosure.

Like reference numbers and designations in the various drawings indicate like elements. It is also to be understood that the various exemplary implementations shown in the figures are merely illustrative representations and are not necessarily drawn to scale.

### DETAILED DESCRIPTION

This specification relates to memory devices, memory systems, and methods for managing initialization in DRAM memory devices. Initialization in DRAM memory devices includes writing pre-set data in memory cells in the DRAM memory devices. Since DRAM is volatile memory, data stored in a DRAM memory device cannot be preserved when power is turned off. Before using a DRAM memory device (e.g., a DRAM memory device with error correction functions), the memory device needs to be initialized by writing pre-set data into all memory cells of the memory device.

In some cases, the initialization process is implemented by sending multiple write commands and pre-set data (e.g., all "0" or all "1") from a memory controller to the memory device. For example, each write command instructs the memory device to write the pre-set data in a portion of the memory array (e.g., one or more rows of a memory bank of the memory array). However, as the storage size of DRAM memory devices increases (e.g., to 16Gb, 32Gb, 64GB or above), the initialization process may require sending a large number of write commands from the memory controller to the memory device, which can take a long time and impact the efficiency of the memory device.

The present disclosure provides techniques to initialize a DRAM memory device based on a write initialization command. In some implementations, a memory controller can send a write initialization command to the memory device. The write initialization command can instruct the memory device to initialize one or more memory banks of the memory array. In some implementations, the write initialization command indicates initializing all memory banks in the memory device (e.g., all memory banks in each bank group). In some implementations, the write initialization command indicates initializing selected memory banks in the memory device (e.g., target memory banks in each bank group).

In response to receiving the write initialization command, the memory device can write pre-set data in memory cells of the one or more memory banks, without needing to receive multiple write commands from the memory controller during the initialization process. For example, the memory device can internally read data (e.g., from one or more mode registers of the memory device), and write the data (e.g., by incrementing the write address, until data are written into all memory cells of a memory bank) in the one or more memory banks.

In some implementations, the memory controller can hold off sending an operation command (e.g., a read command, a write command, etc.) to operate on the memory device for a pre-set duration, during which the memory device initializes the memory banks. In some implementations, the memory device can set the status of designated mode registers to indicate whether the memory banks are initialized. The memory controller can thereby determine whether the memory banks are initialized by reading the status of designated mode registers. In some implementations, the memory device can set the voltage of data input/output (I/O) pins of data lines to indicate whether the memory banks are initialized. The memory controller can thereby determine whether the memory banks are initialized by sensing the voltage of the data I/O pins.

Implementations of the present disclosure can provide one or more of the following technical advantages. For example, initialing multiple memory banks using a write initialization command can reduce the time and power consumption needed for the initialization process, which can increase the efficiency of the DRAM memory device. For another example, since the initialization process can be implemented using simplified operations (e.g., without relying on a large number of write commands), data integrity of the memory system can be improved. In addition, the disclosed techniques are cost-efficient since they do not require significantly adding hardware sources on the memory controller or the memory device. In some implementations, additional or different technical effects can be achieved.

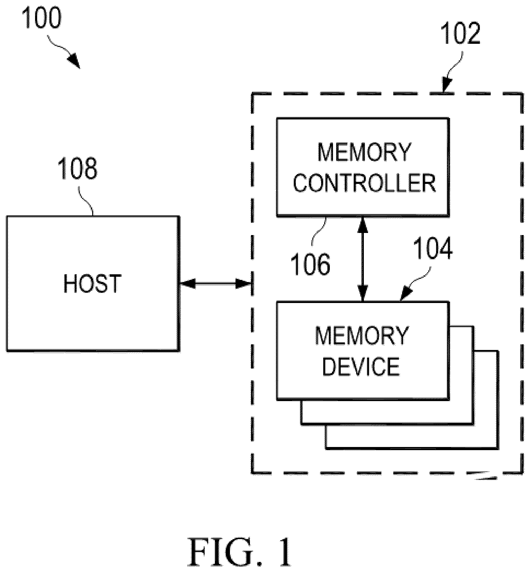

FIG. 1 illustrates a block diagram of an example system 100 having one or more semiconductor devices (e.g., memory devices), according to some aspects of the present disclosure. The system 100 can be a mobile phone, a desktop computer, a laptop computer, a tablet, a server, a vehicle computer, a gaming console, a printer, a positioning device, a wearable electronic device, a smart sensor, a virtual reality (VR) device, an argument reality (AR) device, or any other suitable electronic devices having storage therein. As shown in FIG. 1, the system 100 can include a host 108 and a memory system 102 having one or more memory devices 104 and a memory controller 106. Host 108 can include a processor of an electronic device, such as a central processing unit (CPU), or a system-on-chip (SoC), such as an application processor (AP). Host 108 can be configured to send or receive data to or from the one or more memory devices 104.

A memory device 104 can be any memory device disclosed herein. In some implementations, the memory device 104 includes a DRAM memory. Memory controller 106 (a.k.a., a controller circuit) is coupled to memory device 104 and host 108. Consistent with implementations of the present disclosure, memory device 104 can include a plurality of conductive interconnections through a cover layer that are in contact with conductive pads in a conductive pad layer, and memory controller 106 can be coupled to memory device 104 through at least one of the plurality of conductive interconnections. Memory controller 106 is configured to control memory device 104. Memory controller 106 can manage data stored in memory device 104 and communicate with host 108.

In some implementations, memory controller 106 can be configured to control operations of memory device 104, such as read, program (or write) operations. Memory controller 106 can also be configured to manage various functions with respect to the data stored or to be stored in memory device 104 including, but not limited to bad-block management, garbage collection, logical-to-physical address conversion, wear leveling, etc. In some implementations, memory controller 106 is further configured to process error correction codes (ECCs) with respect to the data read from or written to memory device 104. Any other suitable functions may be performed by memory controller 106 as well, for example, formatting memory device 104.

Memory controller 106 can communicate with an external device (e.g., host 108) according to a particular communication protocol. For example, memory controller 106 may communicate with the external device through at least one of various interface protocols, such as a USB protocol, a peripheral component interconnection (PCI) protocol, a PCIexpress (PCI-E) protocol, an advanced technology attachment (ATA) protocol, a serial-ATA protocol, a parallel-ATA protocol, a small computer small interface (SCSI) protocol, an enhanced small disk interface (ESDI) protocol, an integrated drive electronics (IDE) protocol, a Firewire protocol, etc.

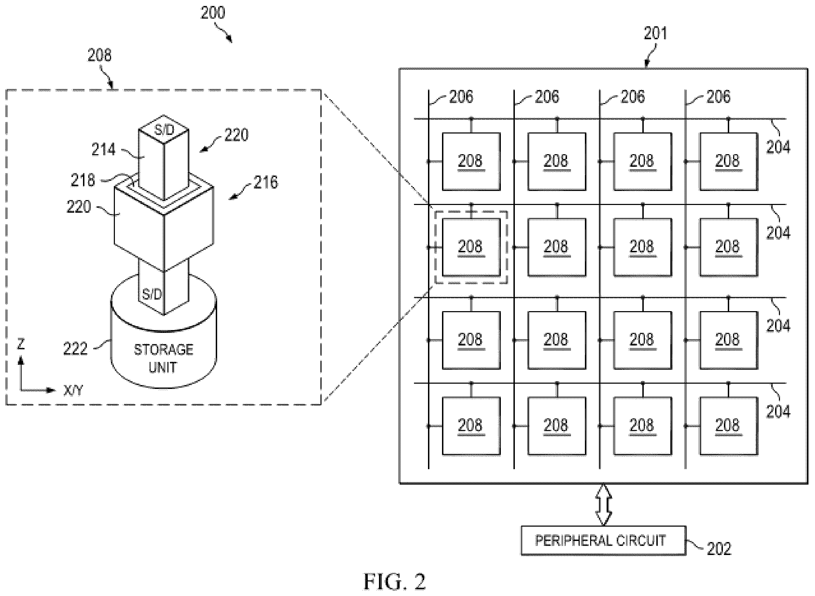

FIG. 2 illustrates a schematic diagram of a memory device 200 including peripheral circuits and an array of memory cells each having a vertical transistor, according to some aspects of the present disclosure. Memory device 200 can include a memory array 201 and peripheral circuits 202 coupled to memory array 201. Memory array 201 can be any suitable memory array in which each memory cell 208 includes a vertical transistor 210 and a storage unit 212 coupled to vertical transistor 210. In some implementations, memory array 201 is a DRAM cell array, and storage unit 212 is a capacitor for storing charge as the binary information stored by the respective DRAM cell. In some implementations, memory array 201 is a PCM cell array, and storage unit 212 is a PCM element (e.g., including chalcogenide alloys) for storing binary information of the respective PCM cell based on the different resistivities of the PCM element in the amorphous phase and the crystalline phase. In some implementations, memory array 201 is a FRAM cell array, and storage unit 212 is a ferroelectric capacitor for storing binary information of the respective FRAM cell based on the switch between two polarization states of ferroelectric materials under an external electric field.

As shown in FIG. 2, memory cells 208 can be arranged in a two-dimensional (2D) array having rows and columns. Memory device 200 can include word lines 204 coupling peripheral circuits 202 and memory array 201 for controlling the switch of vertical transistors 210 in memory cells 208 located in a row, as well as bit lines 206 coupling peripheral circuits 202 and memory array 201 for sending data to and/or receiving data from memory cells 208 located in a column. That is, each word line 204 is coupled to a respective row of memory cells 208, and each bit line is coupled to a respective column of memory cells 208.

Consistent with the scope of the present disclosure, vertical transistors 210, such as vertical metal-oxide-semiconductor field-effect transistors (MOSFETs), can replace the planar transistors as the pass transistors of memory cells 208 to reduce the area occupied by the pass transistors, the coupling capacitance, as well as the interconnect routing complexity, as described below in detail. As shown in FIG. 2, in some implementations, different from planar transistors in which the active regions are formed in the substrates, vertical transistor 210 includes a semiconductor body 214 extending vertically (in the Z-direction) above the substrate (not shown). That is, semiconductor body 214 can extend above the top surface of the substrate to allow channels to be formed not only at the top surface of semiconductor body 214, but also at one or more side surfaces thereof. As shown in FIG. 2, for example, semiconductor body 214 can have a cuboid shape to expose four sides thereof. It is understood that semiconductor body 214 may have any suitable 3D shape, such as polyhedron shapes or a cylinder shape. That is, the cross-section of semiconductor body 214 in the plan view (e.g., in the X-Y plane) can have a square shape, a rectangular shape (or a trapezoidal shape), a circular (or an oval shape), or any other suitable shapes. It is understood that consistent with the scope of the present disclosure, for semiconductor bodies that have a circular or oval shape of their cross-sections in the plan view, the semiconductor bodies may still be considered as having multiple sides, such that the gate structures is in contact with more than one side of the semiconductor bodies. As described below with respect to the fabrication process, semiconductor body 214 can be formed from the substrate (e.g., by etching or epitaxy) and thus, has the same semiconductor material (e.g., silicon crystalline silicon) as the substrate (e.g., a silicon substrate).

As shown in FIG. 2, vertical transistor 210 can also include a gate structure 216 in contact with one or more sides of semiconductor body 214, e.g., in one or more planes of the side surface(s) of the active region. In other words, the active region of vertical transistor 210, e.g., semiconductor body 214, can be at least partially surrounded by gate structure 216. Gate structure 216 can include a gate dielectric 218 over one or more sides of semiconductor body 214, e.g., in contact with four side surfaces of semiconductor body 214, as shown in FIG. 2. Gate structure 216 can also include a gate electrode 220 over and in contact with gate dielectric 218. Gate dielectric 218 can include any suitable dielectric materials, such as silicon oxide, silicon nitride, silicon oxynitride, or high-k dielectrics. For example, gate dielectric 218 may include silicon oxide, which is a form of gate oxide. Gate electrode 220 can include any suitable conductive materials, such as polysilicon, metals (e.g., tungsten (W), copper (Cu), aluminum (Al), etc.), metal compounds (e.g., titanium nitride (TiN), tantalum nitride (TaN), etc.), or silicides. For example, gate electrode 220 may include doped polysilicon, which is a form of a gate poly. In some implementations, gate electrode 220 includes multiple conductive layers, such as a W layer over a TiN layer. It is understood that gate electrode 220 and word line 204 may be a continuous conductive structure in some examples. In other words, gate electrode 220 may be viewed as part of word line 204 that forms gate structure 216, or word line 204 may be viewed as the extension of gate electrode 220 to be coupled to peripheral circuits 202.

As shown in FIG. 2, vertical transistor 210 can further include a pair of a source and a drain (S/D, dope regions, a.k.a., source electrode and drain electrode) formed at the two ends of semiconductor body 214 in the vertical direction (the Z-direction), respectively. The source and drain can be doped with any suitable P-type dopants, such as boron (B) or Gallium (Ga), or any suitable N-type dopants, such as phosphorus (P) or arsenic (As). The source and drain can be separated by gate structure 216 in the vertical direction (the Z-direction). In other words, gate structure 216 is formed vertically between the source and drain. As a result, one or more channels (not shown) of vertical transistor 210 can be formed in semiconductor body 214 vertically between the source and drain when a gate voltage applied to gate electrode 220 of gate structure 216 is above the threshold voltage of vertical transistor 210. That is, each channel of vertical transistors 210 is also formed in the vertical direction along which semiconductor body 214 extends, according to some implementations.

In some implementations, as shown in FIG. 2, vertical transistor 210 is a multi-gate transistor. That is, gate structure 216 can be in contact with more than one side of semiconductor body 214 (e.g., four sides in FIG. 2) to form more than one gate, such that more than one channel can be formed between the source and drain in operation. That is, different from the planar transistor that includes only a single planar gate (and resulting in a single planar channel), vertical transistor 210 shown in FIG. 2 can include multiple vertical gates on multiple sides of semiconductor body 214 due to the 3D structure of semiconductor body 214 and gate structure 216 that surrounds the multiple sides of semiconductor body 214. As a result, compared with planar transistors, vertical transistor 210 shown in FIG. 2, can have a larger gate control area to achieve better channel control with a smaller subthreshold swing. Since the channel is fully depleted, the leakage current (Ioff) of vertical transistor 210 can be significantly reduced as well. As described below in detail, the multi-gate vertical transistors can include double-gate vertical transistors (e.g., dual-side gate vertical transistors), tri-gate vertical transistors (e.g., tri-side gate vertical transistors), and GAA vertical transistors.

It is understood that although vertical transistor 210 is shown as a multi-gate transistor in FIG. 2, the vertical transistors disclosed herein may also include single-gate transistors as described below in detail. That is, gate structure 216 may be in contact with a single side of semiconductor body 214, for example, for the purpose of increasing the transistor and memory cell density. It is also understood that although gate dielectric 218 is shown as being separate (a separate structure) from other gate dielectrics of adjacent vertical transistors (not shown), gate dielectric 218 may be part of a continuous dielectric layer having multiple gate dielectrics of vertical transistors.

In planar transistors and some lateral multiple-gate transistors (e.g., FinFET), the active regions, such as semiconductor bodies (e.g., Fins), extend laterally (in the X-Y plane), and the source and the drain are disposed at different locations in the same lateral plane (the X-Y plane). In contrast, in vertical transistor 210, semiconductor body 214 extends vertically (in the Z-direction), and the source and the drain are disposed in the different lateral planes, according to some implementations. In some implementations, the source and the drain are formed at two ends of semiconductor body 214 in the vertical direction (the Z-direction), respectively, thereby being overlapped in the plan view. As a result, the area (in the X-Y plane) occupied by vertical transistor 210 can be reduced compared with planar transistors and lateral multiple-gate transistors. Also, the metal wiring coupled to vertical transistors 210 can be simplified as well since the interconnects can be routed in different planes. For example, bit lines 206 and storage units 212 may be formed on opposite sides of vertical transistor 210. In one example, bit line 206 may be coupled to the source or the drain at the upper end of semiconductor body 214, while storage unit 212 may be coupled to the other source or the drain at the lower end of semiconductor body 214.

As shown in FIG. 2, storage unit 212 can be coupled to the source or the drain of vertical transistor 210. Storage unit 212 can include any devices that are capable of storing binary data (e.g., 0 and 1), including but not limited to, capacitors for DRAM cells and FRAM cells, and PCM elements for PCM cells. In some implementations, vertical transistor 210 controls the selection and/or the state switch of the respective storage unit 212 coupled to vertical transistor 210.

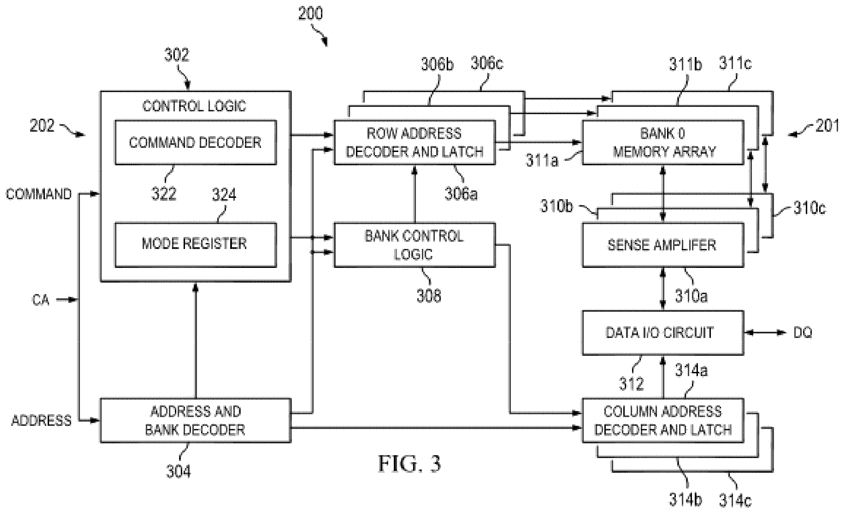

FIG. 3 illustrates memory device having a memory array 201 and an example peripheral circuit 202, according to some aspects of the present disclosure. The peripheral circuit 202 can be coupled to the memory array 201 through bit lines 206 and word lines 204. The peripheral circuit 202 can include any suitable analog, digital, and mixed-signal circuits for facilitating the operations of the memory array 201. The peripheral circuit2 202 can include various types of peripheral circuits formed using metal-oxide-semiconductor (MOS) technologies. The example peripheral circuit 202 include control logic 302, an address and bank decoder 304, a row address decoder and latch 306, bank control logic 308, a sense amplifier 310, a data input/output (I/O) circuit 312, and a column address decoder and latch 314. In some examples, additional peripheral circuits not shown in FIG. 3 may be included as well.

In some implementations, the memory array 201 can include a number of memory banks 311. Each memory bank 311 can include memory cells 208 arranged in rows and in columns. Memory banks 311 can be accessed and operated independently from one another. As an example in FIG. 3, the memory array 201 includes three memory banks 311a, 311b, 311c. In other examples, the memory array 201 can include other numbers of memory banks. In some implementations, each memory bank 311a, 311b, 311c can be controlled by a corresponding row address decoder and latch 308a, 308b, 308c, a corresponding sense amplifier 310a, 310b, 310c, and a corresponding column address decoder and latch 314a, 314b, 314c .

In some implementations, the memory banks can be arranged into bank groups, for example, to facilitate parallel operation of accessing memory banks 311 in different bank groups at the same time. For example, each bank group can include N memory banks 311, and the n^{th} memory bank in different bank groups can be accessed at the same time (e.g., during a read or a write operation).

The control logic 302 can be configured to control operations of other circuits in the peripheral circuit 202. The control logic 302 can include a command decoder 322 configured to decode commands received by the memory device 200 (e.g., from the memory controller 106), and generate instructions to be sent to other circuits such as bank control logic 308 and the row address decoder and latch 306. The control logic can also include a number of registers, such as mode registers 324 that store information such of configuration parameters, circuit status, pre-set data pattern, etc. Different mode registers 324, or different sets of mode registers 324, may be designated for different uses.

The address and bank decoder 304 can be configured to decode address signals received from the memory controller. The address and bank decoder 304 can send row addresses, column addresses, and signals indicating selected memory banks decoded from the address signals to the row address decoder and latch 306, the column address decoder and latch 314, and the bank control logic 308, respectively.

The row address decoder and latch 306 can be configured to decode the row address received from the address and bank decoder 304, and enable a word line connected to a memory cell for data to be written to or to be read from, according to the decoded tow address.

The column address decoder and latch 314 can be configured to decode the column address received from the address and bank decoder 304, ad enable a bit line connected to a memory cell for data to be written to or to be read from, according to the decoded tow address.

The sense amplifier 310 can sense and amplify data of a memory cell and can store data in the memory cell. The sense amplifier 404 can be implemented by a cross-coupled amplifier connected between a bit line and a complementary bit line, which are included in the memory array 201.

The bank control logic 308 can be configured to control operations on selected memory banks 311, for example, by controlling a row address decoder and latch 306a, 306b, 306c, a column address decoder and latch 314a, 314b, 314c, and/or a sense amplifier 310a, 310b, 310c that correspond to a selected memory bank 311a, 311b, 311c.

The data input/output circuit 312 can write input data to the memory array 201, and can read output data from the memory array 201. The data input/output circuit 312 can include a read latch to temporality hold output data to be read, and a write latch to temporality hold output data to be written. In some implementations, the data input/output circuit 312 can include data masking logic configured to select certain portions of data, for example, by masking invalid data bits and keeping valid data bits in a read or a write operation.

The peripheral circuits may further include a clock circuit for generating a clock signal, a power supply circuit generating or distributing internal voltages by receiving power supply voltages applied from outside thereof, or the like.

In some implementations, memory cells in the memory array 201 are DRAM cells. Since DRAM is volatile, when power is turned off, data stored in the DRAM cells cannot be preserved. For example, data stored in each memory cell can be in an uncertain state of 0 or 1. Therefore, DRAM needs to be initialized when powered is turned on, e.g., before a user accesses the DRAM for read or write operations. In some implementations, the initialization process includes writing pre-set data in the memory array 201, for example, writing all "1", all "0", or another data pattern in the memory array 201. In some implementations, one or more mode registers 324 can store the pre-set data, so that the initialization process does not involve sending data across a data bus between the memory controller and the memory device. For example, under a write pattern command under DDR5, the memory device can source the input data from the mode registers 324 that store the pre-set data, instead of sourcing the input data from the data (DQ) lines.

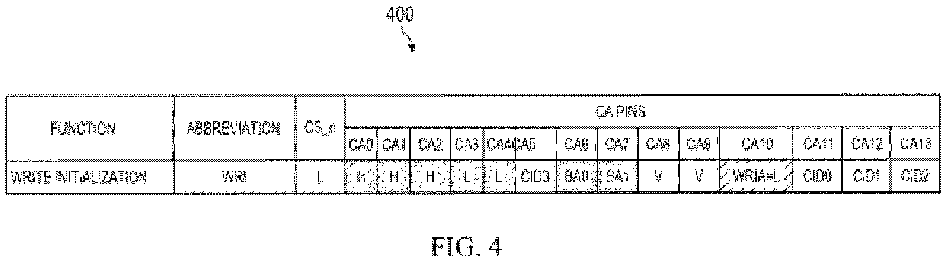

FIG. 4 illustrates a data structure of an example write initialization (WRI) command 400, according to some aspects of the present disclosure. In some implementations, the WRI command includes 14 bits, each bit to be received by a pin of a command/address (CA) interface. The 14 bits can be referred to as CA<13:0>.

As shown in FIG. 4, the first five bits (e.g., CA<4:0>) can be used as an identifier to indicate a command type. A bit is set to "0" when the voltage of the corresponding pin is set to low, and a bit is set to "1" when the voltage of the corresponding pin is set to high. For example, when CA<4:0> is set to "00111" (voltages at corresponding pins are set to low, low, high, high and high, respectively), it indicates that the received command is a WRI command 400. In some implementations, CA<4:0> can be set to a different data pattern to indicate the WRI command 400, or other bits in the WRI command 400 can be used to indicate the command type.

In some implementations, a bit (e.g., CA<10>) in the WRI command 400 can be used as an identifier that indicates an initialization mode. For example, when CA<10> is set as 0, it indicates that all memory banks 311 in the memory array 201 will be initialized; when CA<10> is set as 1, it indicates that one or more selected memory banks (also referred to as target memory banks) in each bank group will be initialized, while other memory banks (e.g., memory banks that will not be used in subsequent operations) may remain uninitialized. Some other bits (e.g., CA<7:6>) can be used to indicate the target memory bank in each bank group. For example, suppose that each bank group has four memory banks 311, CA<7:6> can be set to 00 to indicate that the first memory bank in each bank group will be initialized; CA<7:6> can be set to 01 to indicate that the second memory bank in each bank group will be initialized; CA<7:6> can be set to 10 to indicate that the third memory bank in each bank group will be initialized; and CA<7:6> can be set to 11 to indicate that the fourth memory bank in each bank group will be initialized.

In some cases, more than one target bank in each bank group can be initialized. In some implementations, the same bits (e.g., CA<7:6>) can be used to indicate the more than one target bank. For example, suppose that each bank group has four memory banks 311, CA<7:6> can to set to 00 to indicate that the first memory bank in each bank group will be initialized; CA<7:6> can be set to 01 to indicate that the first two memory banks in each bank group will be initialized; CA<7:6> can be set to 10 to indicate that the first three memory banks in each bank group will be initialized; and CA<7:6> can be set to 11 to indicate that all memory banks in each bank group will be initialized. In some implementations, different bits (e.g., CA<9:6>) in the WRI command 400 can be used to indicate the more than one target bank. For example, suppose that each bank group has four memory banks 311, each bit in CA<9:6> can be used to indicate whether a corresponding memory bank will be initialized. As one example, CA<9:6> can be set to "1100" to indicate that the first and second memory banks will be initialized; CA<9:6> can be set to "0111" to indicate the second, third and fourth memory banks will be initialized.

In some implementations, a bit (e.g., CA<5>) can be used to indicate whether the memory array is in a 2D structure (e.g., having one layer of memory cells) or a 3D structure (e.g., having multiple layers of memory cells stacked vertically). Under the 3D structure, some other bits (e.g., CA<13:11>) can be used to indicate selected layers for initialization.

In some implementations, remaining bits (e.g., CA<9:8>) in the WRI command 400 can be used to indicate other configuration information of the initialization process, for example, to indicate the pre-set data to be written into the memory banks. As one example, CA<9:8> can be set to "00" to indicate that "0" will be written into all memory cells of the memory banks to be initialized; CA<9:8> can be set to "01" to indicate that "1" will be written into all memory cells of the memory banks to be initialized; and CA<9:8> can be set to "10" to indicate that pre-set data stored in a mode register will be written into memory cells of the memory banks to be initialized. As another example, pins for CA<9:8> can remain at either high voltage or low voltage, when the WRI command 400 is being sent.

In response to receiving the WRI command, the memory device can initialize memory banks in the memory device. For example, the memory device can utilize the Error Check and Scrub (ECS) function under DDR5, which allows the memory device to internally read data (e.g., from one or more mode registers 324 of FIG. 3) and write the data to the memory array 201. An address counter can increment the column address after writing data in memory cells in a column, until data has been written into all memory cells of a memory bank. As such, the memory device can initialize the memory banks without requiring receiving multiple write commands from the memory controller.

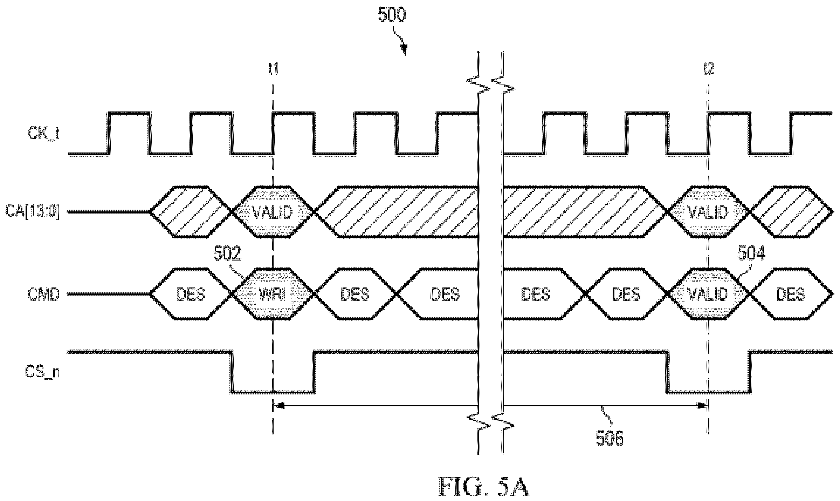

FIG. 5A illustrates a schematic timing diagram of an example method 500 of initializing a memory device, according to some aspects of the present disclosure. The timing diagram can include a clock signal (CK_t) line, a command/address signal (CA<13:0>) line that transmits signals indicating a command (CMD), and a chip select signal (CS_n) line. For example, when CS_n line is set to low, signals on CA<13:0> lines are sampled according to the clock signal, so that the memory device can receive a valid command. In some implementations, a second clock signal (CK_c) line (not shown in FIG. 5A) is used to complement the clock signal (CK_t) line.

In the method 500, after receiving a WRI command 502 (e.g., the WRI command 400 of FIG. 4) from a memory controller, the memory device wait for a pre-set duration 506 before receiving an operation command 504 (e.g., a read command, a write command, an error correction command, etc.). The pre-set duration 506 is equal to or longer than a duration needed to initialize the memory banks in the memory array. As an example in FIG. 5A, after the CS_n line is set low, the CA<13:0> lines transmit the WRI command 502 at t₁. The memory device can initialize memory banks in the memory array in response to the WRI command 502. As the memory banks are being initialized, the memory controller can hold off sending the operation command 504. After the pre-set duration 506, during which the memory banks are initialized, at t₂, the memory device can receive the operation command 504 that indicates to perform operations on the initialized memory banks.

In some implementations, all memory banks in each bank group are initialized in response to the WRI command 502, so that no memory banks can be accessed by a user (e.g., host 108 of FIG. 1) during the pre-set duration 506. In some implementations, only target memory banks in each bank group are initialized in response to the WRI command 502. The user can access other memory banks (e.g., memory banks that have been initialized by a previous WRI command) during the pre-set duration 506.

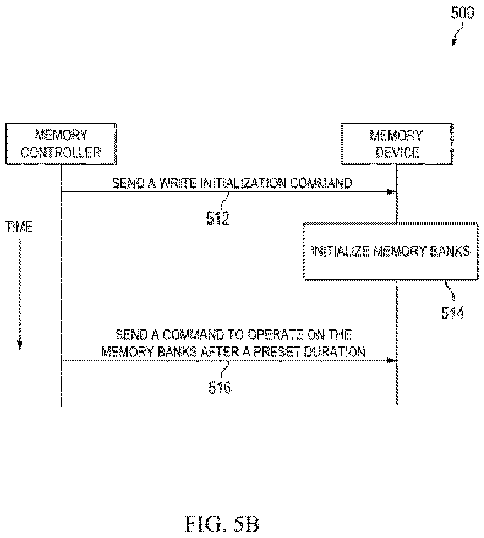

FIG. 5B illustrates the example method 500 of initializing the memory device in FIG. 5A, according to some aspects of the present disclosure. The operations shown in method 500 may not be exhaustive and that other operations can be performed as well before, after, or in between any of the illustrated operations. In some implementations, some of the operations may be performed by or one or more components of a device or a system, such as, a memory controller, or a peripheral circuit of a memory device.

At 512 (e.g., at t₁ of FIG. 5A), the memory controller sends the WRI command 502 to the memory device. The WRI command can instruct the memory device to initialize one or more memory banks in the memory array.

At 514 (e.g., during the pre-set duration 506 of FIG. 5A), the memory device can initialize the one or more memory banks in response to the WRI command 502. In some cases, the initialization can be performed by writing pre-set data stored in one or more mode registers into memory cells of the one or more memory banks, without receiving data from the memory controller. As the memory device initializes the memory banks, the memory controller holds off sending the operation command 504 to operate on the memory banks for a pre-set duration (e.g., the pre-set duration 506 in FIG. 5A).

After the pre-set duration, at 516 (e.g., at t₂ of FIG. 5A), the memory controller sends the operation command 504 to the memory device. The operation command can instruct the memory device to perform an operation such as a read operation, a write operation, an error correction operation, etc. As such, the user can access the memory device by operating on the initialized memory banks.

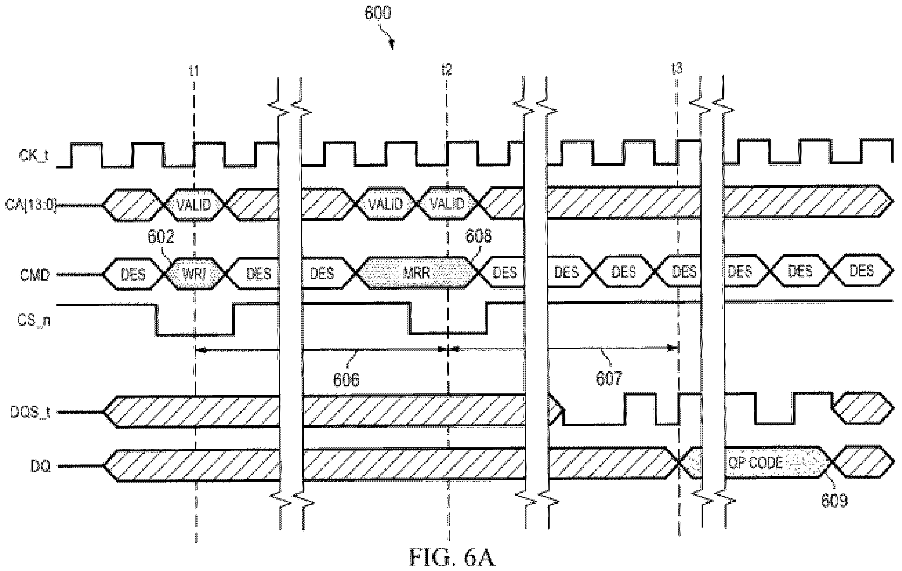

FIG. 6A illustrates a schematic timing diagram of another example method 600 of initializing a memory device, according to some aspects of the present disclosure. The timing diagram can include a clock signal (CK_t) line, a command/address signal (CA<13:0>) line that transmits signals indicating a command (CMD), a chip select signal (CS_n) line, a data strobe signal (DQS_t) line, and data (DQ) lines. For example, when CS_n line is set to low, signals on CA<13:0> lines are sampled according to the clock signal, so that the memory device can receive a valid command. In response to signals on DQS line, data can be sent from the memory device to the memory controller on the data line. In some implementations, a second clock signal (CK_c) line (not shown in FIG. 6A) is used to complement the clock signal (CK_t) line.

In the method 600, after sending a WRI command 602 (e.g., the WRI command 400 of FIG. 4) to a memory device, a memory controller can send a mode register read (MRR) command 608 to the memory device to read the status of designated mode registers (e.g., mode registers 324 of FIG. 3 that are used to indicate whether memory banks are initialized). In response to the MRR command 608, DQ lines can send an operation (OP) code 609 that include the status of the designated mode registers to the memory controller. If the OP code 609 indicates that the memory banks are initialized, the memory controller can then send an operation command (e.g., a read command, a write command, an error correction command, etc.) to the memory device.

As an example in FIG. 6A, after the CS_n line is set low, CA<13:0> lines transmit the WRI command 602 at t₁. The memory device can initialize memory banks in the memory array in response to the WRI command 602. Certain mode registers (e.g., mode register 324 in FIG. 3) can be designated to indicate whether the memory banks have been initialized. For example, a mode register can be designated for each memory bank. After a memory bank is initialized, the memory device can set the status of a corresponding mode register (e.g., from 1 to 0). For another example, a mode register can be designated to indicate whether all memory banks in the memory device have been initialized. After all the memory banks are initialized, the memory device can set the status of the mode register (e.g., from 1 to 0).

After a first duration 606, e.g., at t₂, CA<13:0> lines transmit the MRR command 608 that indicates to read the status of the designated mode registers. In some cases, when the WRI command 602 indicates to initialize target memory banks of each bank group, the user can access other memory banks (e.g., memory banks that have been initialized by a previous WRI command) after the first duration 606.

After a second duration 607, e.g., at t₃, DQ line sends the OP code 609 that includes that status of the designated mode registers. For example, when the OP code 609 is 0, it indicates that the corresponding memory bank has completed initialization and is ready to be accessed by a user; when the OP code 609 is 1, it indicates that the corresponding memory bank in still under initialization. In some cases, if the OP code 609 at t₃ indicates that the corresponding memory bank is still under initialization, the memory controller can send another MRR command 608 to the memory device after t₃.

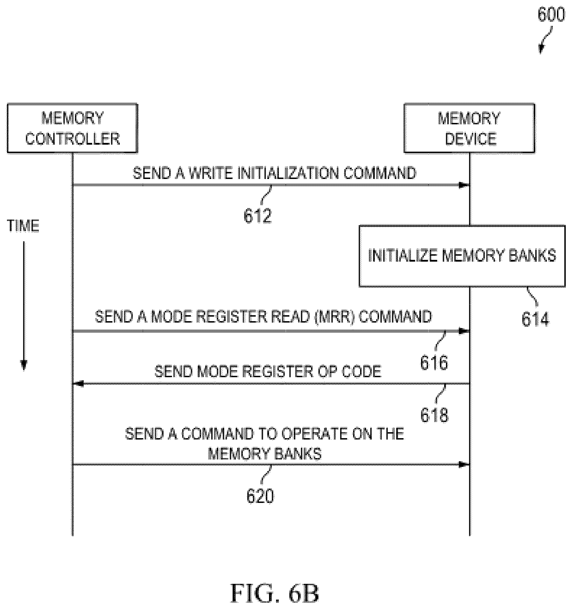

FIG. 6B illustrates the example method 600 of initializing the memory device in FIG. 6A, according to some aspects of the present disclosure. The operations shown in method 600 may not be exhaustive and that other operations can be performed as well before, after, or in between any of the illustrated operations. In some implementations, some of the operations may be performed by or one or more components of a device or a system, such as, a memory controller, or a peripheral circuit of a memory device.

At 612 (e.g., at t₁ of FIG. 6A), the memory controller sends the WRI command 602 to the memory device. The WRI command can instruct the memory device to initialize one or more memory banks in the memory array.

At 614, the memory device can initialize the one or more memory banks in response to the WRI command 602. In some cases, the initialization can be performed by writing pre-set data stored in one or more mode registers into memory cells of the one or more memory banks, without receiving data from the memory controller. After the one or more memory banks are initialized, the memory device can set the status of designated mode register.

After a first duration (e.g., the first duration 606 of FIG. 6A) from sending the WRI command 602, at 616 (e.g., at t₂ of FIG. 6A), the memory controller sends the mode register read (MRR) command 608 to the memory device. The MRR command 608 can instruct the memory device to read the status of the designated mode registers to determine whether the one or more memory banks have been initialized.

After a second duration (e.g., the second duration 607 of FIG. 6A) from sending the MRR command 608, at 618 (e.g., at t₃ of FIG. 6A), the memory device sends the OP code 609 that includes the status of the designated mode registers. The OP code 609 can indicate whether the one or more memory banks have been initialized.

If the OP code 609 indicates that the one or more memory banks have been initialized, at 620, the memory controller sends an operation command to the memory device. The operation command can instruct the memory device to perform an operation such as a read operation, a write operation, an error correction operation, etc. As such, the user can access the memory device by operating on the initialized memory banks.

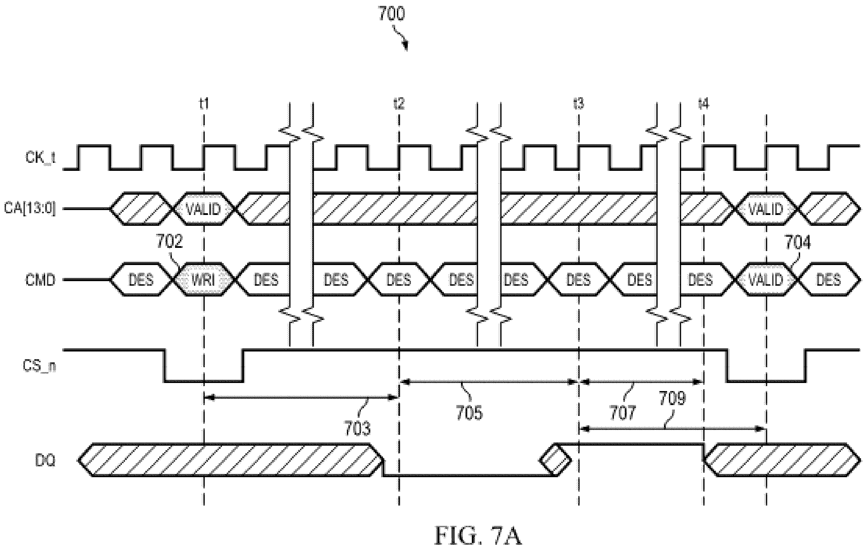

FIG. 7A illustrates a schematic timing diagram of yet another example method 700 of initializing a memory device, according to some aspects of the present disclosure. The timing diagram can include a clock signal (CK_t) line, a command/address signal (CA<13:0>) line that transmits signals indicating a command (CMD), a chip select signal (CS_n) line, and data (DQ) lines. For example, when CS_n line is set to low, signals on CA<13:0> lines are sampled according to the clock signal, so that the memory device can receive a valid command.

In the method 700, after receiving a WRI command 702 (e.g., the WRI command 400 of FIG. 4) to from a memory controller, a memory device can set the voltage of one or more data I/O pins of the DQ lines to a first state (e.g., low), which indicates memory banks in the memory device are under initialization. After the memory banks are initialized, the memory device can set the voltage of the or more pins of the DQ lines to a second state (e.g., high). As such, the memory controller can determine whether the memory device has completed the initialization process based on voltages on the DQ lines. In some implementations, a second clock signal (CK_c) line (not shown in FIG. 7A) is used to complement the clock signal (CK_t) line.

As an example in FIG. 7A, after the CS_n line is set low, CA<13:0> lines transmit the WRI command 702 at t₁. After a first duration 703, e.g., at t₂, the data I/O pins of the DQ lines are set to low voltage, and stay at low voltage for a second duration 705. During the first duration 703 and the second duration 705, the memory device can initialize memory banks in the memory array in response to the WRI command 702.

After the memory banks are initialized, at t₃, the data I/O pins of the DQ line are set to high voltage, and stay at high voltage for a third duration 707. After a fourth duration 709 from t₃, e.g., at t₄, the memory device can receive an operation command 704 (e.g., a read command, a write command, an error correction command, etc.) that indicates to perform operations on the initialized memory banks.

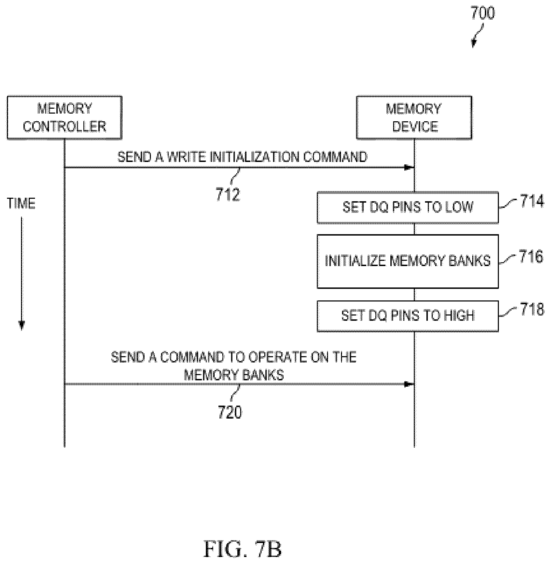

FIG. 7B illustrates the example method 700 of initializing the memory device in FIG. 7A, according to some aspects of the present disclosure. The operations shown in method 700 may not be exhaustive and that other operations can be performed as well before, after, or in between any of the illustrated operations. In some implementations, some of the operations may be performed by or one or more components of a device or a system, such as, a memory controller, or a peripheral circuit of a memory device.

At 712 (e.g., at t₁ of FIG. 7A), the memory controller sends the WRI command 702 to the memory device. The WRI command 702 can instruct the memory device to initialize one or more memory banks in the memory array.

After a first duration (e.g., the first duration 703 of FIG. 7A) from sending the WRI command 702, at 714 (e.g., at t₂ of FIG. 7A), the memory device sets the voltage of the DQ I/O pins to the first state (e.g., low), which indicates that the one or more memory banks are under initialization. The memory device can hold the voltage of the DQ I/O pins as the first state for a second duration (e.g., the second duration 705 of FIG. 7A).

At 716 (e.g., during the second duration), the memory device initializes the one or more memory banks in response to the WRI command 702. In some cases, the initialization can be performed by writing pre-set data stored in one or more mode registers into memory cells of the one or more memory banks, without receiving data from the memory controller.

After the second duration from setting the voltage of the DQ I/O pins to the first state, at 718 (e.g., at t₃ of FIG. 7A), the memory device sets the voltage of the DQ I/O pins to the second state (e.g., high), which indicates that the one or more memory banks have been initialized. The memory device can hold the voltage of the DQ I/O pins as the second state for a third duration (e.g., the third duration 707 of FIG. 7A)

After a fourth duration (e.g., the fourth duration 709 of FIG. 7A) from setting the voltage of the DQ I/O pins to the second state, at 720, the memory controller sends the operation command 704 to the memory device. The operation command 704 can instruct the memory device to perform an operation such as a read operation, a write operation, an error correction operation, etc. As such, the user can access the memory device by operating on the initialized memory banks.

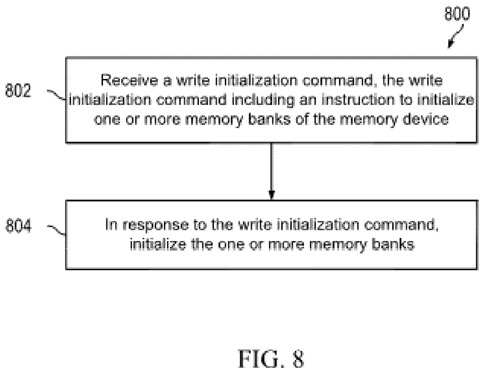

FIG. 8 is a flow chart of an example process 800 of initializing a memory device, according to some aspects of the present disclosure. The process 800 can be performed by any suitable device or system as described herein, for example, according to the example techniques described with respect to FIGS. 1-7B. The memory device can be the memory device 104 of FIG. 1, the memory device 200 of FIGs. 2-3. The process 800 includes operations that can be performed with any suitable order and/or any combination.

At 802, the memory device receives a write initialization command (e.g., the write initialization command 400 of FIG. 4, the write initialization command 502 of FIG. 5A, the write initialization command 602 of FIG. 6A, or the write initialization command 702 of FIG. 7A). The write initialization command can include an instruction to initialize one or more memory banks (e.g., memory banks 311a, 311b, 311c of FIG. 3) of the memory device. In some implementations, the write initialization command indicates initializing all memory banks in each bank group. In some implementations, the write initialization command indicates initializing target memory banks in each bank group.

In some implementations, the write initialization command includes a first identifier that indicates a pattern of pre-set data to be written into the one or more memory banks during the initialization process, a second identifier that indicates the write initialization command, a third identifier that indicates whether to initialize all memory banks or target memory banks in each bank group, and/or a fourth identifier that indicates the target memory bank of each bank group. For example, the memory device can set one or more registers to store the pre-set data according to the pattern indicated by the first identifier.

At 804, in response to the write initialization command, the memory device initializes the one or more memory banks. Initializing the one or more memory banks includes writing pre-set data in memory cells of the one or more memory banks. In some cases, the pre-set data are stored in one or more mode registers (e.g., mode registers 324 of FIG. 3).

After the one or more memory banks are initialized, the memory device can receive an operation command (e.g., the operation command 504 of FIG. 5A, or the operation command 704 of FIG. 7A) that indicates to perform an operation (e.g., a read operation, a write operation, an error correctio operation, etc.) on the initialized memory banks. As such, a user (e.g., the host 108 of FIG. 1) can access the memory device.

In some implementations, as shown in FIGs. 5A-5B, the memory device can wait for a pre-set duration (e.g., the pre-set duration 506 of FIG. 5A) before receiving the operation command. The memory device can initialize the memory banks during the pre-set duration. In some implementations, as shown in FIGs. 6A-6B, the memory device can set the status of designated mode registers to indicate whether the memory banks are initialized. The memory controller can thereby determine whether the memory banks are initialized by reading the status of designated mode registers. In some implementations, as shown in FIGs. 7A-7B, the memory device can set the voltage of data I/O pins of DQ lines to indicate whether the memory banks are initialized. The memory controller can thereby determine whether the memory banks are initialized based on the voltage of the data I/O pins.

It is noted that references in the present disclosure to "one embodiment," "an embodiment," "an example embodiment," "some implementations," "some implementations," etc., indicate that the embodiment described can include a particular feature, structure, or characteristic, but every embodiment can not necessarily include the particular feature, structure, or characteristic. Moreover, such phrases do not necessarily refer to the same embodiment. Further, when a particular feature, structure or characteristic is described in connection with an embodiment, it would be within the knowledge of a person skilled in the pertinent art to affect such feature, structure or characteristic in connection with other implementations whether or not explicitly described.

In general, terminology can be understood at least in part from usage in context. For example, the term "one or more" as used herein, depending at least in part upon context, can be used to describe any feature, structure, or characteristic in a singular sense or can be used to describe combinations of features, structures or characteristics in a plural sense. Similarly, terms, such as "a," "an," or "the," again, can be understood to convey a singular usage or to convey a plural usage, depending at least in part upon context. In addition, the term "based on" can be understood as not necessarily intended to convey an exclusive set of factors and may, instead, allow for existence of additional factors not necessarily expressly described, again, depending at least in part on context.

It should be readily understood that the meaning of "on," "above," and "over" in the present disclosure should be interpreted in the broadest manner such that "on" not only means "directly on" something, but also includes the meaning of "on" something with an intermediate feature or a layer therebetween. Moreover, "above" or "over" not only means "above" or "over" something, but can also include the meaning it is "above" or "over" something with no intermediate feature or layer therebetween (i.e., directly on something).

Further, spatially relative terms, such as "beneath," "below," "lower," "above," "upper," and the like, can be used herein for ease of description to describe one element or feature's relationship to another element(s) or feature(s) as illustrated in the figures. The spatially relative terms are intended to encompass different orientations of the device in use or process step in addition to the orientation depicted in the figures. The apparatus can be otherwise oriented (rotated 90 degrees or at other orientations) and the spatially relative descriptors used herein can likewise be interpreted accordingly.

As used herein, the term "substrate" refers to a material onto which subsequent material layers are added. The substrate includes a "top" surface and a "bottom" surface. The top surface of the substrate is typically where a semiconductor device is formed, and therefore the semiconductor device is formed at a top side of the substrate unless stated otherwise. The bottom surface is opposite to the top surface and therefore a bottom side of the substrate is opposite to the top side of the substrate. The substrate itself can be patterned. Materials added on top of the substrate can be patterned or can remain unpatterned. Furthermore, the substrate can include a wide array of semiconductor materials, such as silicon, germanium, gallium arsenide, indium phosphide, etc. Alternatively, the substrate can be made from an electrically non-conductive material, such as glass, plastic, or sapphire wafer.

As used herein, the term "layer" refers to a material portion including a region with a thickness. A layer has a top side and a bottom side where the bottom side of the layer is relatively close to the substrate and the top side is relatively away from the substrate. A layer can extend over the entirety of an underlying or overlying structure, or can have an extent less than the extent of an underlying or overlying structure. Further, a layer can be a region of a homogeneous or inhomogeneous continuous structure that has a thickness less than the thickness of the continuous structure. For example, a layer can be located between any set of horizontal planes between, or at, a top surface and a bottom surface of the continuous structure. A layer can extend horizontally, vertically, and/or along a tapered surface. A substrate can be a layer, can include one or more layers therein, and/or can have one or more layer thereupon, thereabove, and/or therebelow. A layer can include multiple layers. For example, an interconnect layer can include one or more conductive and contact layers (in which contacts, interconnect lines, and/or vertical interconnect accesses (VIAs) are formed) and one or more dielectric layers.

As used herein, the term "nominal/nominally" refers to a desired, or target, value of a characteristic or parameter for a component or a process step, set during the design phase of a product or a process, together with a range of values above and/or below the desired value. As used herein, the range of values can be due to slight variations in manufacturing processes or tolerances. As used herein, the term "about" indicates the value of a given quantity that can vary based on a particular technology node associated with the subject semiconductor device. Based on the particular technology node, the term "about" can indicate a value of a given quantity that varies within, for example, 10-30% of the value (e.g., ± 10%, ±20%, or ±30% of the value).

In the present disclosure, the term "horizontal/horizontally/lateral/laterally" means nominally parallel to a lateral surface of a substrate, and the term "vertical" or "vertically" means nominally perpendicular to the lateral surface of a substrate. The terms "operation" and "step" can be used interchangeably to describe a process.

The present disclosure provides many different implementations, or examples, for implementing different features of the provided subject matter. Specific examples of components and arrangements are described below to simplify the present disclosure. These are, of course, merely examples and are not intended to be limiting. For example, the formation of a first feature over or on a second feature in the description that follows may include implementations in which the first and second features may be in direct contact, and may also include implementations in which additional features may be formed between the first and second features, such that the first and second features may not be in direct contact. In addition, the present disclosure may repeat reference numerals and/or letters in the various examples. This repetition is for the purpose of simplicity and clarity and does not in itself dictate a relationship between the various implementations and/or configurations discussed.

The foregoing description of the specific implementations can be readily modified and/or adapted for various applications. Therefore, such adaptations and modifications are intended to be within the meaning and range of equivalents of the disclosed implementations, based on the teaching and guidance presented herein.

While the present disclosure contains many specific implementation details, these should not be construed as limitations on the scope of what is being claimed, which is defined by the claims themselves, but rather as descriptions of features that may be specific to particular implementations. Certain features that are described in this present disclosure in the context of separate implementations can also be implemented in combination in a single implementation. Conversely, various features that are described in the context of a single implementation can also be implemented in multiple implementations separately or in any suitable sub-combination. Moreover, although features may be described above as acting in certain combinations and even initially be claimed as such, one or more features from a claimed combination can in some cases be excised from the combination, and the claim may be directed to a sub-combination or variation of a sub-combination.

Similarly, while operations are depicted in the drawings and recited in the claims in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system modules and components in the implementations described above should not be understood as requiring such separation in all implementations, and it should be understood that the described program components and systems can generally be integrated together in a single software product or packaged into multiple software products.

Particular implementations of the subject matter have been described. Other implementations also are within the scope of the following claims. For example, the actions recited in the claims can be performed in a different order and still achieve desirable results. As one example, the processes depicted in the accompanying figures do not necessarily require the particular order shown, or sequential order, to achieve desirable results. In some cases, multitasking and parallel processing may be advantageous.

The breadth and scope of the present disclosure should not be limited by any of the above-described exemplary implementations, but should be defined only in accordance with the following claims and their equivalents.

## Claims

1. A memory device (104, 200), comprising:
a memory array (201) comprising memory banks (311, 311a, 311b, 311c); and
a peripheral circuit (202) coupled to the memory array (201) and configured to perform operations comprising:
receiving a write initialization command, wherein the write initialization command comprises an instruction to initialize one or more memory banks (311, 311a, 311b, 311c); and
in response to the write initialization command, initializing the one or more memory banks (311, 311a, 311b, 311c).

2. The memory device (104, 200) of claim 1, wherein initializing the one or more memory banks (311, 311a, 311b, 311c) comprises:
writing pre-set data in memory cells (208) of the one or more memory banks (311, 311a, 311b, 311c).

3. The memory device (104, 200) of claim 2, wherein a first register of the peripheral circuit (202) stores the pre-set data.

4. The memory device (104, 200) of claim 2, wherein a first identifier of the write initialization command indicates the pre-set data.

5. The memory device (104, 200) of claim 1, wherein the write initialization command comprises a second identifier identifying the write initialization command.

6. The memory device (104, 200) of claim 1, wherein the memory banks (311, 311a, 311b, 311c) are arranged into a plurality of bank groups, and wherein initializing the one or more memory banks (311, 311a, 311b, 311c) comprises:
initializing all memory banks (311, 311a, 311b, 311c) of the plurality of bank groups.

7. The memory device (104, 200) of claim 1, wherein the memory banks (311, 311a, 311b, 311c) are arranged into a plurality of bank groups, and wherein initializing the one or more memory banks (311, 311a, 311b, 311c) comprises:
initializing a target memory bank of a bank group of the plurality of bank groups;
a third identifier indicating whether to initialize all memory banks (311, 311a, 311b, 311c) or the target memory bank of the bank group; and
a fourth identifier indicating the target memory bank.

8. The memory device (104, 200) of claim 1, wherein the operations comprise:
after receiving the write initialization command, receiving a command to perform an operation on the one or more memory banks (311, 311a, 311b, 311c) after a pre-set duration.

9. The memory device (104, 200) of claim 1, wherein the peripheral circuit (202) comprises a second register, and wherein the operations comprise:
setting a status of the second register indicating whether the one or more memory banks (311, 311a, 311b, 311c) are initialized.

10. The memory device (104, 200) of claim 1, wherein the operations comprise:
after receiving the write initialization command, setting a voltage of a data input/output (I/O) pin to a first state; and
after initializing the one or more memory banks (311, 311a, 311b, 311c), setting the voltage of the data I/O pin to a second state.

11. A memory system, comprising:
a memory device (104, 200) comprising a memory array (201) comprising memory banks (311, 311a, 311b, 311c); and
a memory controller (106) coupled to the memory device (104, 200), wherein the memory controller (106) is configured to:
send a write initialization command, wherein the write initialization command comprises an instruction to initialize one or more memory banks (311, 311a, 311b, 311c), and
wherein the memory device (104, 200) is configured to:
receive the write initialization command; and
initialize the one or more memory banks (311, 311a, 311b, 311c).

12. The memory system of claim 11, wherein the memory banks (311, 311a, 311b, 311c) are arranged into a plurality of bank groups, and wherein initializing the one or more memory banks (311, 311a, 311b, 311c) comprises:
initializing all memory banks (311, 311a, 311b, 311c) of the plurality of bank groups.

13. The memory system of claim 11, wherein the memory banks (311, 311a, 311b, 311c) are arranged into a plurality of bank groups, and wherein initializing the one or more memory banks (311, 311a, 311b, 311c) comprises:
initializing a target memory bank of a bank group of the plurality of bank groups.

14. The memory system of claim 13, wherein the write initialization command comprises:
a first identifier indicating whether to initialize all memory banks (311, 311a, 311b, 311c) or the target memory bank of the bank group; and
a second identifier indicating the target memory bank.

15. A method of operating a memory device (104, 200), comprising:
receiving a write initialization command, wherein the write initialization command comprises an instruction to initialize one or more memory banks (311, 311a, 311b, 311c) of the memory device (104, 200); and
in response to the write initialization command, initializing the one or more memory banks (311, 311a, 311b, 311c).
